# EUROPEAN PATENT APPLICATION

(11) **EP 4 733 705 A2**
(43) Date of publication of application: **29.04.2026**
(21) Application number: 25211117.4
(22) Date of filing: 24.10.2025
(51) Int. Cl.: F28F 9/02, F28F 1/40, H05K 7/20, F25B 41/40

(54) **COOLING SYSTEM AND MANIFOLD RECEIVER THEREFOR**

(30) Priority: 24.10.2024 IN 202421081202; 22.10.2025 US 202519365887
(71) Applicant: Vertiv Corporation, Westerville, OH 43082 (US)
(72) Inventor: SHELAR, Kapil Arvind, Westerville, 43082 (US); KATRE, Ankur, Westerville, 43082 (US); PATIL, Shreyas Shivanand, Westerville, 43082 (US); PAWAR, Rajesh, Westerville, 43082 (US); TIPTON, Russell C., Westerville, 43082 (US); WISE, Ashley Elizabeth, Westerville, 43082 (US); SHORES, Craig Nelson, Westerville, 43082 (US); SCHRADER, Timothy James, Westerville, 43082 (US); DUKES, David A, Westerville, 43082 (US); COLE, Andrew Nathan, Westerville, 43082 (US)
(74) Representative: Ambroz, Simon

(57) **Abstract**

A cooling system and manifold receiver for use therein are provided. The cooling system includes a coolant loop configured to circulate a cooling medium, the loop including a heat exchanger, a plurality of conductive heat exchangers that are configured to receive the coolant medium from the heat exchanger and to exchange heat with a heat source, and a manifold receiver. The manifold receiver includes a body defining an elongated cavity therewithin, an inlet providing communication between the cavity and the conductive heat exchangers, an outlet providing communication between the cavity and the heat exchanger, and an element disposed in the cavity. The element is configured to reduce a momentum of the coolant medium within the cavity. The element may include, for example, an elongated pipe body with indentations, grooves, or holes formed therein, or with studs formed thereon.

## Description

### CROSS-REFERENCE TO RELATED APPLICATION(S)

This Application also claims priority from Indian Application 202421081202, filed October 24, 2024 in the Office of the Controller General of Patents, Designs & Trade Marks, India. This Application also claims priority from US Nonprovisional Application 19/365,887, filed 22 October 2025.

### BACKGROUND

### Field

Example embodiments described herein relate to cooling systems, and, more specifically, to a manifold receiver and a cooling system including the manifold receiver.

### Background

A manifold receiver is a component used in systems involved in fluid dynamics, such as gas pipelines, Heat Ventilation and Air Conditioning (HVAC) systems, pumping unit cooling systems, and automotive engines. The manifold receiver is utilized to manage coolant medium (refrigerant) flow by effectively separating liquid and vapor phases. However, related art manifold receivers may limit the overall performance of these systems.

In related art manifold receivers, the rate of the liquid leaving the manifold receiver may be higher than desirable, and therefore much of the refrigerant flow may bypass the liquid accumulation area and moves directly to the outlet. This reduces the accumulation of liquid inside the manifold and negatively affect the efficiency and performance of the components downstream of the manifold receiver.

Additionally, the inclusion of a typical filter or screen in a manifold receiver may contributes to an increased pressure drop which may further diminish system efficiency and may contribute to the effects of insufficient liquid accumulation.

### SUMMARY

Example embodiments may address at least the above such drawbacks and/or disadvantages and other disadvantages not described above. Also example embodiments are not required to overcome the disadvantages described above, and may not overcome any of the problems described above.

According to an aspect of one or more example embodiments, a cooling system may comprise: a coolant loop configured to circulate a coolant medium therewithin, the coolant loop comprising: a heat exchanger; a plurality of conductive heat exchangers configured to receive the coolant medium from the heat exchanger and to exchange heat with a heat source; and a manifold; wherein the manifold comprises: a body defining an elongated cavity therewithin; at least one inlet providing fluid communication between the cavity and the plurality of conductive heat exchangers; at least one outlet providing fluid communication between the cavity and the heat exchanger; and an element disposed within the cavity, wherein the element is configured to reduce a momentum of the coolant medium within the cavity.

According to an example implementation, the coolant loop may be a first coolant loop and the coolant medium is a refrigerant; and the cooling system may further comprise a second coolant loop configured to circulate water therewithin, the second coolant loop comprising the heat exchanger.

According to an example implementation, the element may comprise: a body comprising a flow displacement configuration formed thereon, the flow displacement configuration comprising at least one of: a plurality of indentations in the body, a helical groove in the body, a plurality of holes formed through the body; and a plurality of studs protruding from the body.

According to an example implementation, the body of the element may be substantially cylindrical, and the flow displacement configuration may comprise a helical groove formed in at least one of an inner circumferential surface of the body and an outer circumferential surface of the body of the element.

According to an example implementation, a pitch of the helical groove may vary along a length of the body of the element.

According to an example implementation, the body of the element may be substantially cylindrical, and the flow displacement configuration comprises a plurality of holes formed through the body of the element.

According to an example implementation, a density of an arrangement of the plurality of holes may vary along a length of the body of the element.

According to an example implementation, the body of the element may be substantially cylindrical, and the flow displacement configuration may comprise a plurality of studs extending from at least one of an inner circumferential surface of the body of the element and an outer circumferential surface of the body of the element.

According to an example implementation, a density of an arrangement of the plurality of studs may vary along a length of the body of the element.

According to an aspect of one or more example embodiments, a coolant manifold may comprise: a body defining an elongated cavity therewithin; at least one inlet providing fluid communication between the cavity and the plurality of conductive heat exchangers; at least one outlet providing fluid communication between the cavity and the heat exchanger; and an element disposed within the cavity, wherein the element is configured to reduce a momentum of the coolant medium within the cavity.

According to an example implementation, the element may comprise: a tubular body having a longest dimension extending along a longest dimension of the cavity; and a flow displacement configuration formed on the tubular body, the flow displacement configuration comprising at least one of: a plurality of indentations in the tubular body, a helical groove in the tubular body, a plurality of holes formed through the tubular body; and a plurality of studs protruding from the tubular body

According to an example implementation, the flow displacement configuration may comprise a helical groove formed in at least one of an inner circumferential surface of the tubular body and an outer circumferential surface of the tubular body.

According to an example implementation, a pitch of the helical groove may vary along a length of the tubular body.

According to an example implementation, the flow displacement configuration may comprise a plurality of holes formed through the tubular body.

According to an example implementation, a density of an arrangement of the plurality of holes may vary along a length of the tubular body.

According to an example implementation, the flow displacement configuration may comprise a plurality of studs extending from at least one of an inner circumferential surface of the tubular body and an outer circumferential surface of the tubular body.

According to an example implementation, a density of an arrangement of the plurality of studs may vary along a length of the tubular body.

### BRIEF DESCRIPTION OF THE DRAWINGS

The description of the present disclosure will now be described with the help of the accompanying drawing, in which: The above and other objects, advantages, and salient features will become apparent to those skilled in the art from the following detailed description of example embodiments when taken in conjunction with the accompanying drawings in which:
FIG. 1 is a schematic of a related art system including a pumping unit including a related art receiver;
FIG. 2 is a schematic of a cooling system according to one or more example embodiments;
FIG. 3 schematically illustrates a related art manifold receiver;
FIG. 4A schematically illustrates a manifold receiver according to an example embodiment;
FIG. 4B schematically illustrates an internal element of FIG. 4A;
FIG. 5A schematically illustrates a manifold receiver according to another example embodiment;
FIGs. 5B and 5C illustrate schematic cross-sectional views of internal elements of FIG. 5A;
FIG. 5D schematically illustrates a manifold receiver according to another example embodiment;
FIGs. 5E and 5F illustrate schematic cross-sectional views of internal elements of FIG. 5D;
FIGs. 5G-5I illustrate example shapes of studs of the internal elements of FIGs. 5A-5F;
FIG. 6A schematically illustrates a manifold receiver according to another example embodiment;
FIG. 6B illustrates a schematic cross-sectional view of an internal element of FIG. 4A;
FIG. 7 schematically illustrates a manifold receiver according to another example embodiment;
FIG. 8A illustrates a representation of liquid accumulation in the related art manifold receiver of FIG. 3; and
FIGs. 8B-8D illustrate representations of liquid accumulation in manifold receivers according to example embodiments.

### DETAILED DESCRIPTION

Reference will now be made in detail to example embodiments which are illustrated in the accompanying drawings, wherein like reference numerals refer to like elements throughout. In this regard, the example embodiments may have different forms and may not be construed as being limited to the descriptions set forth herein.

It will be understood that the terms "include," "including", "comprise, and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," and/or other, may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list.

Expressions of relational orientation, such as "upper," "lower," "inside," "outside," and/or other expressions, which are used for explaining the structural positions of various components as described herein, are not absolute but relative. The orientation expressions are appropriate when the various components are arranged as shown in the figures, but should change accordingly when the positions of the various components in the figures change.

Various terms and expressions are used herein to refer to particular components. Different companies may refer to a component by different names. This document does not intend to distinguish between components that differ in name but not function.

Matters of these example embodiments that are obvious to those of ordinary skill in the technical field to which these example embodiments pertain may not be described here in detail.

One of more example embodiments described herein may provide a manifold receiver with enhanced liquid and vapor phase separation.

One of more example embodiments described herein may provide a manifold receiver with improved liquid accumulation and improved vapor at an outlet thereof.

One of more example embodiments described herein may provide a manifold receiver enabling a reduction in the pressure drop of the coolant medium flow.

One of more example embodiments described herein may provide a manifold receiver that can be operated in any inclined orientation.

Many liquid cooling solutions for data centers utilize a manifold in which a coolant medium/refrigerant is dispersed to individual servers. Pumped 2 phase (P2P) cooling systems may utilize a separator, which splits the vapor/liquid coolant mixture exiting the servers into vapor and liquid parts. The vapor is directed to a compressor, while the liquid is directed to a receiver. The receiver stores additional liquid coolant, which is typically sent back to the servers to perform further cooling. Proper separation of the liquid and vapor parts is important as the vapor exiting the receiver enters a compressor, which is not built to intake liquid coolant. Also, the accumulation of liquid is helpful to ensure that the server always has access to liquid coolant.

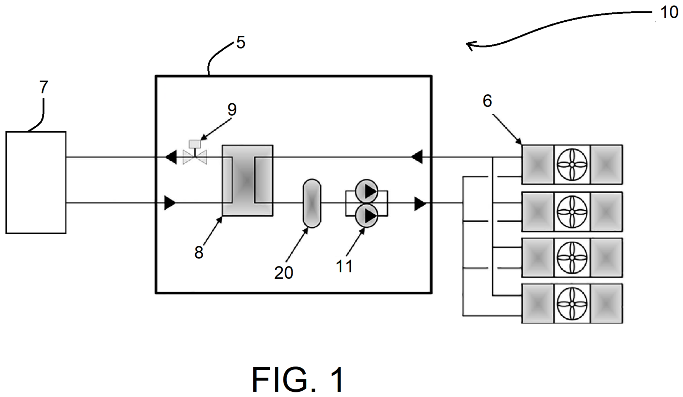

FIG. 1 is a schematic of a related art system 10 including a pumping unit 5 operationally disposed between cooling modules 6 and a water system 7. The pumping unit 5 includes a heat exchanger 5 that receives water from the water system 7 and outputs chilled water via a control valve 9. Pumps 1 pump refrigerant through a cycle between the cooling modules 6 and the heat exchanger 8. The receiver 20 is included in this cycle within the pumping unit 5 and is operationally disposed on the line between the heat exchanger 8 and the pumps 1.

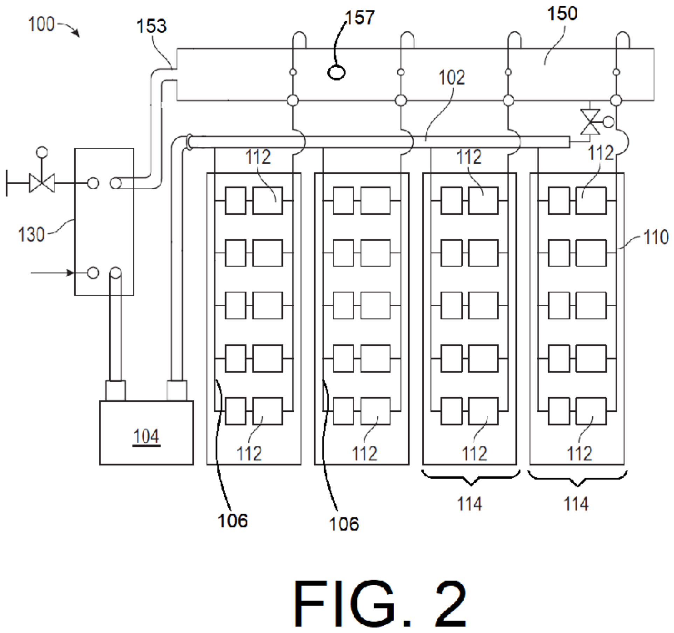

FIG. 2 schematically illustrates a cooling system 100 according to one or more example embodiments. The cooling system 100 includes a pump or pump unit 104 configured to supply a refrigerant, such as in liquid form, to one or more supply manifolds 102. The supply manifold 102 may be disposed horizontally, as shown, but this is merely an example, and the supply manifold may be disposed in another orientation, as would be understood by one of skill in the art. The supply manifold 102, in turn, provides the refrigerant to first vertical manifolds 106. A plurality of parallel heat exchangers 112 are connected in parallel with one another between the first vertical manifolds 106 and second vertical manifolds 110. The first and second manifolds 106 and 110 are illustrated in FIG. 2 and are described herein as vertical; however, this is merely an example, and the first and second manifolds 106 and 110 may be disposed in another orientation, as would be understood by one of skill in the art. The parallel heat exchangers 112 may be conductive heat exchangers such as two-phase cold plates, but this is merely an example, and the parallel heat exchangers 112 may be any of various other types of heat exchangers as would be understood by one of skill in the art. Each of the parallel heat exchanger 112 may be thermally coupled to a processor, processing unit, or other heat source within one or more computer equipment racks or cabinets 114. The computer equipment racks or cabinets 114 may, for example, hold any heat source needing cooling, as would be understood by one of skill in the art, such as servers. The second vertical manifolds 110 provide the refrigerant to at least one manifold receiver 150. A heat exchanger 130, for example a brazed plate heat exchanger, which may be connected to a facility's chilled water system, receives the refrigerant from the outlet 153 of the manifold receiver 150. As discussed in further detail herein, each of the one or more manifold receivers 150 of the system 100 may be any manifold receiver according to any of the example embodiments described herein. According to one or more example embodiments, an internal volume, such as an internal volume, of one or more manifold receivers 150 may function within the cooling system 100 as a vapor receiver for accommodating changes in vapor volume, such as in response to changes in a thermal load of the system 100 during cooling operations. For example, at least a portion of one or more manifold receivers 150 may be positioned above computer equipment mounted to the racks or cabinets 114. Thus, according to one or more example embodiments, the one or more manifold receivers, functioning as one or more vapor receivers or vapor tanks, need not occupy valuable space within a pump unit 104 or elsewhere in a row of computer equipment racks or cabinets 114, which may thereby contribute to maximizing cooling density.

According to one or more example embodiments, both the supply manifold 102 and the manifold receiver 150 are perfectly level horizontally. Alternately, one or both of the supply manifold 102 and the manifold receiver 150 may be at least substantially level horizontally, may be intentionally inclined, and/or adjustment features may be included in the system 100 and/or the racks 114 configured to level the supply manifold 102 and/or the manifold receiver 150.

According to one or more example embodiments, the refrigerant may be pumped and may be in a liquid form (or phase) upstream of the parallel heat exchangers 112. Depending on a thermal load of the system 100, a portion of the refrigerant may turn to vapor upon extracting heat from the parallel heat exchangers 112, and thus from the processors or other heat sources cooled by the parallel heat exchangers 112. For example, at full system heat load, most or all of the refrigerant may be in a vapor phase upon leaving the parallel heat exchangers 112, and at no system heat load, most or all of the refrigerant may be in a liquid phase upon leaving the parallel heat exchangers 112.

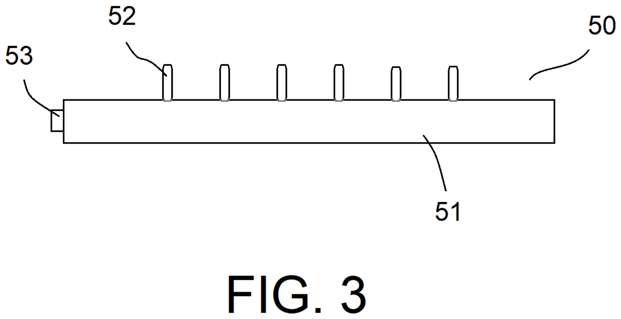

FIG. 3 schematically illustrates a related art manifold receiver 50 including a body 51, one or more inlets 52, one or more outlets 53 (one illustrated). A coolant medium/refrigerant enters the receiver 50 via the one or more inlets 52 and is discharged via the one or more outlets 53. The system 100 may include manifold receiver 50 as the manifold receiver 150.

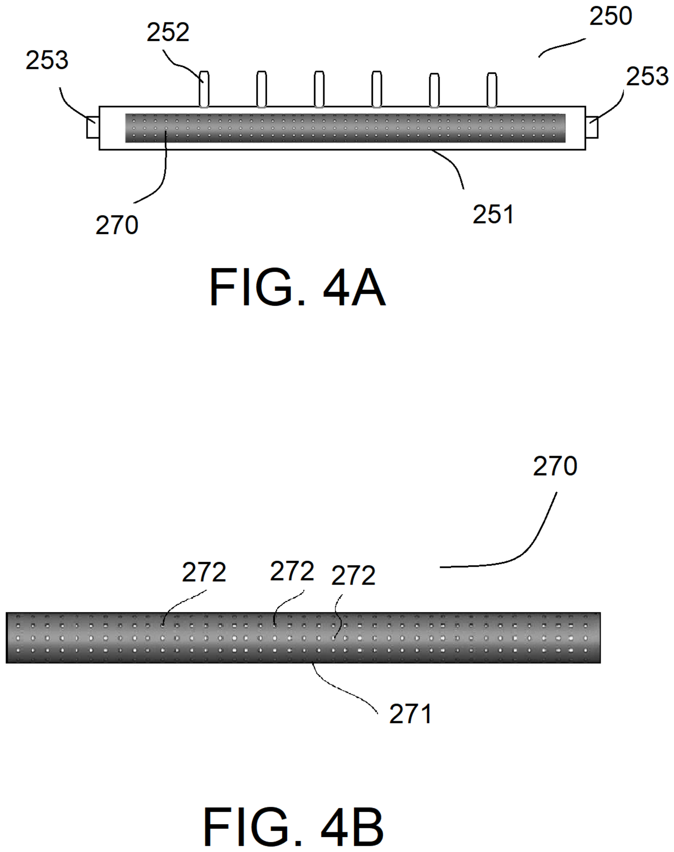

FIG. 4A schematically illustrates a manifold receiver 250 according to an example embodiment, and FIG. 4B schematically illustrates the internal element 270 of the manifold receiver 250. The manifold receiver 250 includes a body 251, one or more inlets 252, one or more outlets 253. As shown in FIG. 4A, the body 251 is substantially tubular and is oriented in a horizontal position with the inlet(s) 252 disposed on a substantially upper surface thereof, and the outlet(s) 253 disposed at one or both ends thereof. This arrangement is merely an example. The body 251 may have a substantially cylindrical shape, but may, alternately, have another, less symmetric shape, for example. Furthermore, while the body 251 may be oriented in a horizontal direction, according to one or more alternate embodiments, the body 251 may be oriented in a vertical direction or in an inclined direction. The inlets 252, as illustrated, may be evenly spaced, but this is merely an example, and the receiver 250 may include one or more inlets 252, and a plurality of inlets 252 may be spaced evenly or not, as would be understood by one of skill in the art. The receiver may include one or more outlets 253.

The element 270 is disposed within the body 251 of the receiver 250 and, as shown in FIG. 4B, may be oriented such that a longest dimension of the element 270 extends substantially parallel to the longest dimension of the receiver body 251. The element 270 may be disposed substantially along a radial center of the body 251 or may be inclined with respect to the radial center of the body 251 or may be offset from the radial center of the body 251 of the receiver 250. For example, where one or more inlets 252 are disposed along a first side of the body 251 of the receiver 250, the element 270 may be disposed closer to a second side of the body 251, opposite the first side. The element may be configured such that it extends along a large percentage of the length of the body 251 in order to enable improved vapor and liquid separation by slowing the liquid coolant flow through the body 251. For example, the element may extend through 80-90 percent of the length of the body 251.

As shown in FIGs. 2A and 2B, the element 270 according to one or more example embodiments may be a strainer pipe comprising a substantially cylindrical pipe body 271 with a plurality of indentations/holes 272 formed therein. The indentations/holes 272 may be divots indented into one or both of the outer circumferential surface of the body 271 and the inner circumferential surface of the body 271. Alternately, the indentations/holes 272 may be holes formed through the body 271. The indentations/holes 272 may be of substantially equal size and shape and may be evenly spaced in an array, as shown. Alternately, the indentations/holes may have varying shapes and sizes and may be irregularly arranged. For example, the indentations/holes 272 may have a uniform density over a length of the body 271, or a density of the indentations/holes 272 may vary over the length of the body 271. The indentations/holes 272 may all have substantially the same diameter and depth, or one or more of the diameter and depth of the indentations/holes 272 may vary along a length of the body 271. The pipe body 271 may be formed from a corrosion resistant material such as, for example, copper, stainless steel, or another metal, but is not limited thereto.

The element 270 including the indentations/holes 272 is configured such that, as compared to a receiver without the element 270 therewithin, the placement of the element 270 within the receiver body 271 reduces the flow of the liquid coolant within the receiver and thereby facilitates the phase separation of the coolant. The presence of the element 270 within the receiver body 271, and the inclusion of the indentations/holes 272 causes perturbations in the flow of the coolant from the one or more inlets 252 to the one or more outlets 253, thereby reducing the momentum of the coolant within the receiver body 271.

The reduction in the momentum of the coolant within the receiver body 271 thus enables greater phase separation and greater accumulation of the liquid coolant inside the receiver body 271 while the vapor is discharged through the outlet(s) 273.

According to one or more example implementations, the inclusion of the element 270 within the receiver body 271 may lead to a 12-18 percent improvement in the performance of the receiver 250.

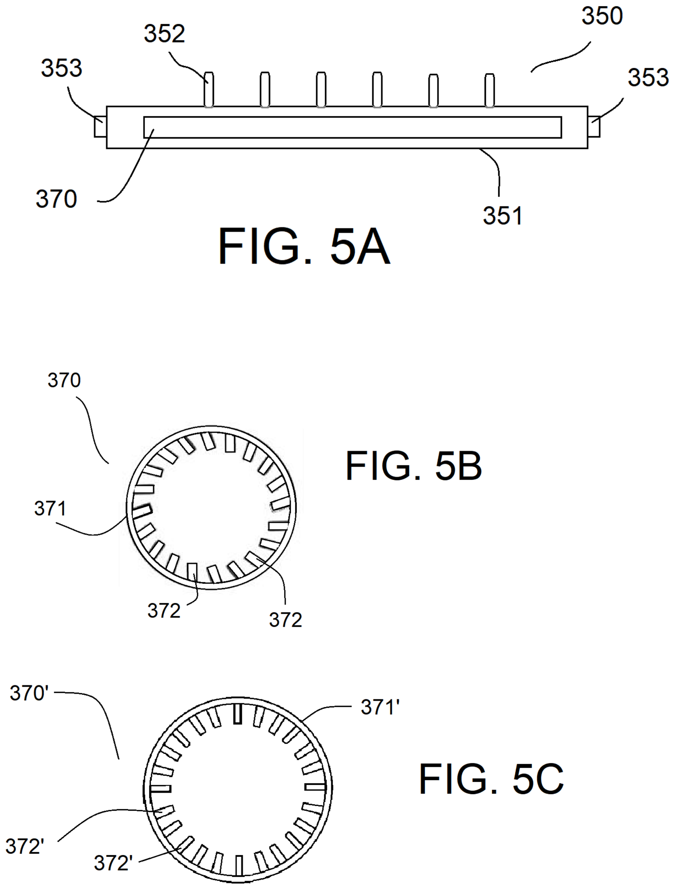

FIG. 5A schematically illustrates a manifold receiver 350 according to another example embodiment, and FIG. 5B illustrates a schematic cross-sectional view of the internal element 370 of the receiver 350. Analogous to the receiver 250 of FIG. 4A, the receiver 350 includes a body 351, one or more inlets 352, and one or more outlets 353.

The element 370 is disposed within the body 351 of the receiver 350. As discussed with respect to the embodiments of FIGs. 4A and 4B, the specific relative dimensions and orientations of the element 370 and the receiver 350 of FIGs. 5A and 5B are not limited to those illustrated.

As shown in FIG. 5B, the element 370 according to one or more example embodiments may be a studded pipe comprising a substantially cylindrical pipe body 371 with a plurality of studs 372 formed thereon. The studs 372 may be formed on an internal circumferential of the body 371, as shown. Alternately, the studs may be formed on the outer circumferential surface of the body 371, or on both the inner and outer circumferential surfaces. The studs 372 may be of substantially equal size and shape and may be evenly spaced in an array over the surface of the pipe body 371. Also, as shown in FIG. 5B, the studs 372 may extend inward (or outward, not shown) from the surface of the pipe body 371. As shown in FIG. 5B, the studs may extend inward (or outward, not shown) at varying angles. Alternately, as shown in the schematic cross-sectional view of internal element 370' of FIG. 5C, the studs 372' may each extend directly radially inward toward a center of the pipe body 371' (or outward directly away from the center of the pipe body 371', not shown). Furthermore, the studs 372, 372' may alternately may have varying shapes and sizes and/or may be irregularly arranged. For example, the studs 372, 372' may be arranged with a uniform density, height, thickness, and shape over the body 371, 371', or one or more of the density, height, thickness, and shape of the studs 372, 372' may vary over the body 371, 371'. The pipe body 371, 371' and the studs 372, 372' may be formed from a corrosion resistant material such as, for example, copper, stainless steel, or another metal, but is not limited thereto.

The element 370, 370' including the studs 372, 372' may be configured such that, as compared to a receiver without the element 370, 370' therewithin, the placement of the element 370, 370' within the receiver body 351 reduces the momentum of the liquid coolant within the receiver body. When the coolant flow contacts the studs 372, 372', perturbations in the flow of the coolant reduce the momentum of the coolant flow while promoting phase separation. This results in increased liquid accumulation within the receiver 350.

According to one or more example implementations, the inclusion of the element 370, 370' within the receiver body 351 may lead to a 30-35 percent improvement in the liquid accumulation in the receiver 350.

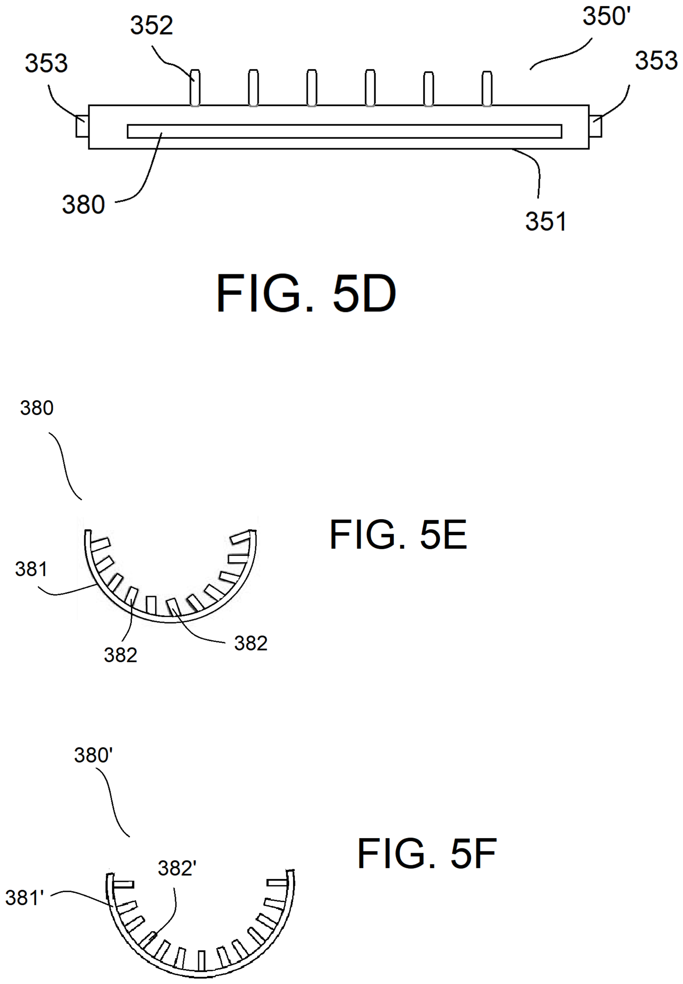

FIG. 5D schematically illustrates a manifold receiver 350' according to another example embodiment, and FIG. 3E illustrates a schematic cross-sectional view of the internal element 380 of the receiver 350'. In contrast to the elements 370, 370' of FIGs. 5A-5C, the element 380 of FIG. 5D may be a studded pipe comprising a semi-cylindrical pipe body, with a plurality of studs 382 formed thereon. Analogous to the receiver 350 of FIGs. 5A-5C, the receiver 350' includes a body 351, one or more inlets 352, and one or more outlets 353.

The element 380 is disposed within the body 351 of the receiver 350'. As with other example embodiments, the specific relative dimensions and orientations of the element 380 and the receiver 350' of FIGs. 5D and 5E are not limited to those illustrated.

As shown in FIG. 5E, the element 380 according to one or more example embodiments may be a studded semi-cylindrical pipe comprising a pipe body 381 with a plurality of studs 382 formed thereon. The studs 382 may be formed on an internal circumferential of the body 381, as shown. Alternately, the studs may be formed on the outer circumferential surface of the body 381, or on both the inner and outer circumferential surfaces.

The studs 382 may be of substantially equal size and shape and may be evenly spaced in an array over the pipe body 381. Also, as shown in FIG. 5E, the studs 382 may extend inward from the internal circumferential surface of the pipe body 381 (or outward from the outer circumferential surface of the body 381, not shown). As shown in FIG. 5E, the studs may extend inward (or outward, not shown) at varying angles. Alternately, as shown in the schematic cross-sectional view of internal element 380' of FIG. 5F, the studs 382' may each extend directly radially inward toward the center of the pipe body 381' (or outward directly away from the center of the pipe body 381', not shown). Furthermore, the studs 382, 382' may alternately have varying shapes and sizes. The studs 382, 382' may be irregularly arranged. For example, the studs 382, 382' may be arranged with a uniform density, height, thickness, and shape over the body 381, 381', or one or more of the density, height, thickness, and shape of the studs 382, 382' may vary over the body 381, 381'. The pipe body 381, 381' and the studs 382, 382' may be formed from a corrosion resistant material such as, for example, copper, stainless steel, or another metal, but is not limited thereto.

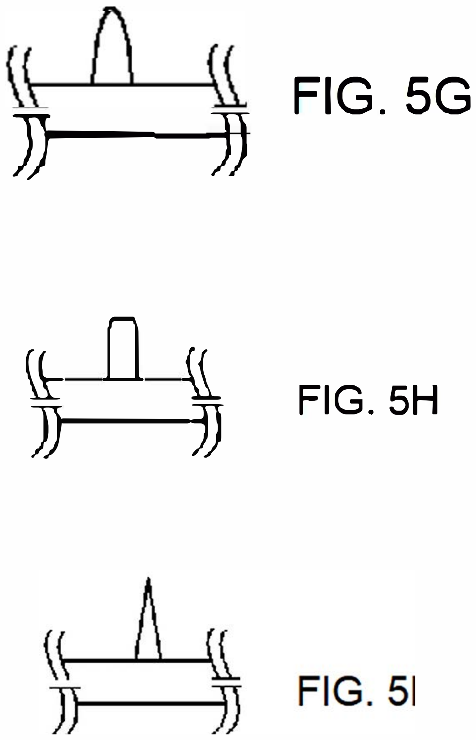

The studs 372, 372', 382, 382' of the example embodiments described above may be of substantially equal size and shape or may have various different sizes and shapes, as noted. The relative dimensions of the studs and the shapes as illustrated in FIGs. 5A-5F are merely examples and the studs may have any of various other dimensions and shapes, such as, but not limited to the curved, rounded, and pointed shapes of FIGs. 5G, 5H, and 5I, respectively.

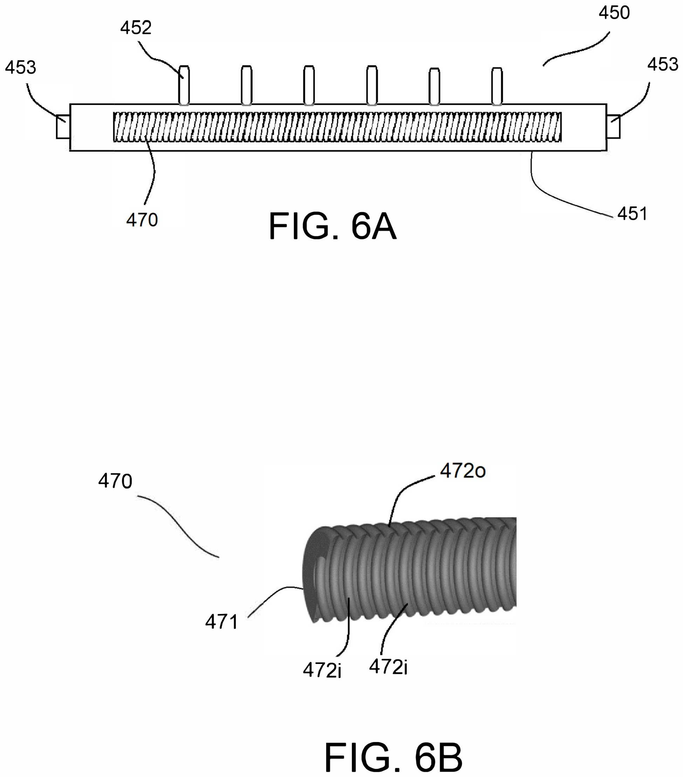

As shown in FIGs. 6A and 6B, the element 470 according to one or more example embodiments may be a grooved pipe. The grooved pipe 470 may have a substantially cylindrical pipe body 471 with helical grooves 472 formed on one or both of the inner and outer circumferential surfaces thereof. As shown in FIG. 6B, inner helical grooves 472i may be formed on an inner circumferential surface of the pipe body 471, and outer helical grooves 472o may be formed on an outer circumferential surface of the pipe body 471. According to one or more other example implementations, the helical grooves 472 may be formed on only an outer surface or only an inner surface of the pipe body 471.

The grooves 472 may be of substantially equal size and shape, as shown, or, alternately, may have varying shapes and sizes and may be irregularly arranged. For example, the grooves 472 may have an equal pitch along a length of the pipe body 47,1 or the pitch of the grooves 472 may vary over the length of the pipe body 471. The pipe body 471 may be formed from a corrosion resistant material such as, for example, copper, stainless steel, or another metal, but is not limited thereto.

The element 470 including the helical grooves 472 may be configured such that, as compared to a receiver without the element 470 therewithin, the placement of the element 470 within the receiver body 451 may reduce a pressure drop of the coolant within the receiver 450. As the coolant flows within a receiver body including the element 470, the presence of the grooves 472 may enhance a swirling motion of the coolant, thereby reducing a momentum thereof, promoting better phase separation, and increasing liquid accumulation within the receiver 450.

According to one or more example implementations, the inclusion of the element 470 within the receiver body 451 may lead to a 100 to 110 percent improvement in liquid accumulation within the receiver 450.

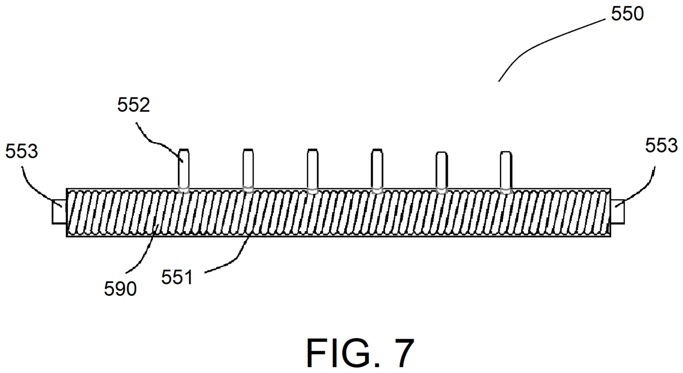

FIG. 7 schematically illustrates a manifold receiver 550 according to another example embodiment. As shown in FIG. 7, the manifold receiver 550 like those described hereinabove, includes a substantially tubular body 551, one or more inlets 552, and one or more outlets 553. According to this example embodiment, an inner surface of the body 551 has helical grooves 590 formed therein. As with the other example embodiments described herein, The shape, number, and arrangement of the inlets 552 and outlets 553 is not limited to those illustrated in FIG. 7. The body 551 is shown as oriented in a horizontal direction, but alternately, may be oriented in a vertical direction or in an inclined direction. While no element is illustrated as disposed within the receiver 550 of the example embodiment of FIG. 7, any one of the elements described herein may be disposed within the body 551 of the receiver 550, according to one or more example embodiments.

As the momentum of the coolant flow decreases within a manifold receiver according to one or more example embodiments described herein, the forces that aid in mixing the liquid and vapor are reduced. This enhances phase separation, allowing vapor to rise and exit through the outlet(s) while enabling the liquid to settle efficiently at the bottom of the manifold receiver body. In the manifold receiver according to one or more example embodiments, having an adequate amount of liquid coolant contributes to efficient operation. Liquid accumulation contributes to ensuring that there is enough coolant to absorb heat effectively and as phase separation improves, more liquid coolant can accumulate at the bottom of the manifold receiver. This increases the availability of liquid for further cooling processes, enhancing overall system efficiency.

The combination of reduced momentum, improved phase separation, and increased liquid accumulation contributes to the overall efficiency of a cooling system. This can lead to better temperature control and energy savings. Therefore, a manifold receiver according to one or more example embodiments described herein may improve the reliability of a cooling system by reducing the likelihood of vapor carryover into sections of the system where liquid is needed.

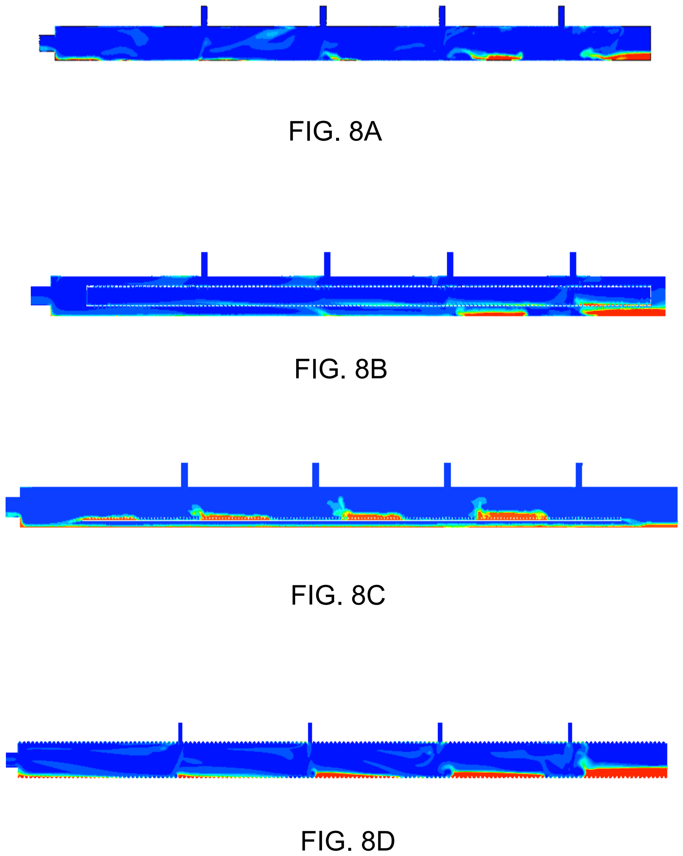

FIG. 8A illustrates the relative accumulation of liquid with respect to vapor in the related art manifold receiver of FIG. 3. FIGs. 8B, 8C, and 8D illustrate the relative accumulation of liquid with respect to vapor in the manifold receivers according to the example embodiments of FIGs. 4A, 5D, and 7, respectively.

Regarding an internal volume of a manifold receiver according to any one of the example embodiments described herein, as incorporated into a cooling system, such as cooling system 100 of FIG. 2, the following terms may be used. An internal volume of the supply manifold 102 may be referred to as a supply internal volume; an internal volume of the first vertical manifold 106 may be referred to as a first internal volume; an internal volume of the horizontal return manifold 108 may be referred to as a return internal volume; an internal volume of the second vertical manifold 110 may be referred to as a second internal volume; a collective internal volume of the plurality of two-phase parallel heat exchangers 112 may be referred to as a collective internal cold plate volume. According to one or more example embodiments, an internal volume of the manifold receiver 150 may be greater than a sum of the second internal volume and the collective internal cold plate volume. According to one or more example embodiments, an internal volume of the manifold receiver 150 may be greater than 1.5 times a sum of the second internal volume and the collective internal cold plate volume. According to one or more example embodiments, an internal volume of the manifold receiver 150 may be greater than 1.5, 1.7, 1.9 times, or twice a sum of the second internal volume and the collective internal cold plate volume. According to one or more example embodiments, an internal volume of the manifold receiver 150 and the return internal volume may be sized and configured by one of skill in the art with an aim of receiving enough vapor during cooling operations so as to minimize the size of, or eliminate, any vapor receiver or vapor tank other than the manifold receiver 150 within the system.

According to one or more example embodiments, the manifold receiver 150 may be sized or otherwise configured to receive vapor from the parallel heat exchangers 112, such as upstream of the heat exchanger 130, which can include when some or most (or all) of the refrigerant flow is in a vapor phase. According to one or more example embodiments, the manifold receiver 150 may be sized or otherwise configured to receive vapor from the parallel heat exchangers 112, such as fluidically between the parallel heat exchangers 112 and the heat exchanger 130, at full system heat load, when most of the refrigerant flow is in a vapor phase, plus a volume of liquid equal to, or greater than, the sum of the second internal volume, the collective internal cold plate volume, the collective internal hose volume, or any combination thereof.

These above-described examples of the internal volume of the manifold receiver 150 and its example relationships to volumes of other respective elements of the system 100 may apply to the internal volume of any manifold receiver according any of the example embodiments described herein.

A manifold receiver according to any one of the example embodiments described herein may include one or more sight glasses 157, as shown in the manifold receiver 150 of FIG. 2, configured to allow visual observation of a liquid level of the refrigerant within the manifold receiver. A manifold receiver according to any one of the example embodiments described herein may include a single sight glass spanning most or all of a vertical height of the manifold receiver, and/or may include a plurality of sight glasses, each spanning a portion of the vertical height of the manifold receiver.

A manifold receiver according to any one of the example embodiments described herein may include one or more outlet ports sized to accommodate flow, such as a rated flow of the refrigerant at no system heat load, when the refrigerant flow is in a liquid phase. According to an example implementation, one or more outlet ports may have a smaller internal cross sectional area than that of the manifold receiver itself. According to an example implementation, an outlet port may be configured such that a liquid level of a refrigerant within a manifold receiver may be even with a top of the outlet port at no system heat load, when the refrigerant flow is in a liquid phase. According to an example implementation, an outlet port may be configured such that a liquid level of the refrigerant within a manifold receiver may occupy less than half, less than one quarter, less than one fifth, or less than one tenth of an internal cross sectional area of the manifold receiver at full system heat load, when most of the refrigerant flow is in a vapor phase. According to an example implementation, an outlet port may be configured such that a liquid level of a refrigerant within a manifold receiver may be proportional to the system heat load, such that as the system heat load increases from no system heat load to full system heat load, the liquid level of the refrigerant within the manifold receiver increases from at or near a bottom of the outlet port to at or near a top of the outlet port.

While aspects and implementation of example embodiments have been shown and described herein, it will be understood by those skilled in the art that various changes in form and details may be made therein. It may be understood that example embodiments described herein may be considered in a descriptive sense only and not for purposes of limitation. Descriptions of features, aspects, or implementations within each example embodiment may be considered as available for other similar features, aspects, or implementations in other example embodiments.

Described herein are also the following clauses:
1. A cooling system comprising: a coolant loop configured to circulate a coolant medium therewithin, the coolant loop comprising: a heat exchanger; a plurality of conductive heat exchangers configured to receive the coolant medium from the heat exchanger and to exchange heat with a heat source; and a manifold; wherein the manifold comprises: a body defining an elongated cavity therewithin; at least one inlet providing fluid communication between the cavity and the plurality of conductive heat exchangers; at least one outlet providing fluid communication between the cavity and the heat exchanger; and an element disposed within the cavity, wherein the element is configured to reduce a momentum of the coolant medium within the cavity.
2. The cooling system according to clause 1, wherein: the coolant loop is a first coolant loop and the coolant medium is a refrigerant; and the cooling system further comprises a second coolant loop configured to circulate water therewithin, the second coolant loop comprising the heat exchanger.
3. The cooling system according to clause 1, wherein the element comprises: a body comprising a flow displacement configuration formed thereon, the flow displacement configuration comprising at least one of: a plurality of indentations in the body, a helical groove in the body, a plurality of holes formed through the body; and a plurality of studs protruding from the body.
4. The cooling system according to clause 3, wherein: the body of the element is substantially cylindrical, and the flow displacement configuration comprises a helical groove formed in at least one of an inner circumferential surface of the body and an outer circumferential surface of the body of the element.
5. The cooling system according to clause 4, wherein a pitch of the helical groove varies along a length of the body of the element.
6. The cooling system according to clause 3, wherein: the body of the element is substantially cylindrical, and the flow displacement configuration comprises a plurality of holes formed through the body of the element.
7. The cooling system according to clause 6, wherein a density of an arrangement of the plurality of holes varies along a length of the body of the element.
8. The cooling system according to clause 3, wherein: the body of the element is substantially cylindrical, and the flow displacement configuration comprises a plurality of studs extending from at least one of an inner circumferential surface of the body of the element and an outer circumferential surface of the body of the element.
9. The cooling system according to clause 8, wherein a density of an arrangement of the plurality of studs varies along a length of the body of the element.
10. A coolant manifold comprising: a body defining an elongated cavity therewithin; at least one inlet providing fluid communication between the cavity and the plurality of conductive heat exchangers; at least one outlet providing fluid communication between the cavity and the heat exchanger; and an element disposed within the cavity, wherein the element is configured to reduce a momentum of the coolant medium within the cavity.
11. The coolant manifold according to clause 10, wherein the element comprises: a tubular body having a longest dimension extending along a longest dimension of the cavity; and a flow displacement configuration formed on the tubular body, the flow displacement configuration comprising at least one of: a plurality of indentations in the tubular body, a helical groove in the tubular body, a plurality of holes formed through the tubular body; and a plurality of studs protruding from the tubular body
12. The coolant manifold according to clause 11, wherein the flow displacement configuration comprises a helical groove formed in at least one of an inner circumferential surface of the tubular body and an outer circumferential surface of the tubular body.
13. The coolant manifold according to clause 12, wherein a pitch of the helical groove varies along a length of the tubular body.
14. The coolant manifold according to clause 11, wherein the flow displacement configuration comprises a plurality of holes formed through the tubular body.
15. The coolant manifold according to clause 14, wherein a density of an arrangement of the plurality of holes varies along a length of the tubular body.
16. The coolant manifold according to clause 11, wherein the flow displacement configuration comprises a plurality of studs extending from at least one of an inner circumferential surface of the tubular body and an outer circumferential surface of the tubular body.
17. The coolant manifold according to clause 16, wherein a density of an arrangement of the plurality of studs varies along a length of the tubular body.

## Claims

1. A coolant manifold comprising:
a body defining an elongated cavity therewithin;
at least one inlet providing fluid communication between the cavity and the plurality of conductive heat exchangers;
at least one outlet providing fluid communication between the cavity and the heat exchanger; and
an element disposed within the cavity, wherein the element is configured to reduce a momentum of the coolant medium within the cavity.

2. The coolant manifold according to claim 1, wherein the element comprises:
a tubular body having a longest dimension extending along a longest dimension of the cavity; and
a flow displacement configuration formed on the tubular body, the flow displacement configuration comprising at least one of:
a plurality of indentations in the tubular body,
a helical groove in the tubular body,
a plurality of holes formed through the tubular body; and
a plurality of studs protruding from the tubular body

3. The coolant manifold according to claim 2, wherein the flow displacement configuration comprises a helical groove formed in at least one of an inner circumferential surface of the tubular body and an outer circumferential surface of the tubular body.

4. The coolant manifold according to any one of the claims 2 to 3, wherein a pitch of the helical groove varies along a length of the tubular body.

5. The coolant manifold according to any one of the claims 2 to 4, wherein the flow displacement configuration comprises a plurality of holes formed through the tubular body.

6. The coolant manifold according to claim 5, wherein a density of an arrangement of the plurality of holes varies along a length of the tubular body.

7. The coolant manifold according to any one of the claims 2 to 6, wherein the flow displacement configuration comprises a plurality of studs extending from at least one of an inner circumferential surface of the tubular body and an outer circumferential surface of the tubular body.

8. The coolant manifold according to claim 7, wherein a density of an arrangement of the plurality of studs varies along a length of the tubular body.

9. The coolant manifold according to claim 2, wherein:
the body of the element is cylindrical, and
the flow displacement configuration comprises a helical groove formed in at least one of an inner circumferential surface of the body and an outer circumferential surface of the body of the element;
and optionally wherein a pitch of the helical groove varies along a length of the body of the element.

10. The coolant manifold according to claim 2, wherein:
the body of the element is cylindrical, and
the flow displacement configuration comprises a plurality of holes formed through the body of the element;
and optionally, wherein a density of an arrangement of the plurality of holes varies along a length of the body of the element.

11. The coolant manifold according to claim 2, wherein:
the body of the element is cylindrical, and
the flow displacement configuration comprises a plurality of studs extending from at least one of an inner circumferential surface of the body of the element and an outer circumferential surface of the body of the element;
and optionally, wherein a density of an arrangement of the plurality of studs varies along a length of the body of the element.

12. A cooling system comprising:
a coolant loop configured to circulate a coolant medium therewithin, the coolant loop comprising: a heat exchanger;
a plurality of conductive heat exchangers configured to receive the coolant medium from the heat exchanger and to exchange heat with a heat source;
and a coolant manifold according to any one of the claims 1 to 11.

13. The cooling system according to claim 12, wherein:
the coolant loop is a first coolant loop and the coolant medium is a refrigerant; and
the cooling system further comprises a second coolant loop configured to circulate water therewithin, the second coolant loop comprising the heat exchanger.
